# FASCICULE DE BREVET EUROPEEN

(11) **EP 0 599 746 B1**
(45) Date de publication et mention de la délivrance du brevet: **15.04.1998**
(21) Numéro de dépôt: 93420459.5
(22) Date de dépôt: 19.11.1993
(51) Int. Cl.: H03K 23/62

(54) **Compteur rapide permettant alternativement de compter et de décompter des trains d'impulsions**
Schnelle Zähler zum alternativen Auf- und Abzählen von Impulsfolgen
Fast counters for alternately upcounting and downcounting pulse trains

(30) Priorité: 24.11.1992 FR 9214477
(43) Date de publication de la demande: 01.06.1994
(73) Titulaire: SGS-THOMSON MICROELECTRONICS S.A., 94250 Gentilly (FR)
(72) Inventeur: Bonnot, Jean-Louis, F-38340 Voreppe (FR)
(74) Mandataire: de Beaumont, Michel

(56) Documents cités:
- US-A- 2 823 856
- BOUKREEV ET AL 'circuits micro-electroniques et technique numerique' 1975 , MIR , MOSCOU(SU) * page 185, ligne 36 - page 186, ligne 12 * * page 187, ligne 35 - page 188, ligne 23; figure 5.16 * * page 179; figure 5.6B *

## Description

La présente invention concerne les compteurs/ décompteurs et plus particulièrement un compteur/décompteur utilisé pour alternativement compter puis décompter des impulsions de trains d'impulsions successifs.

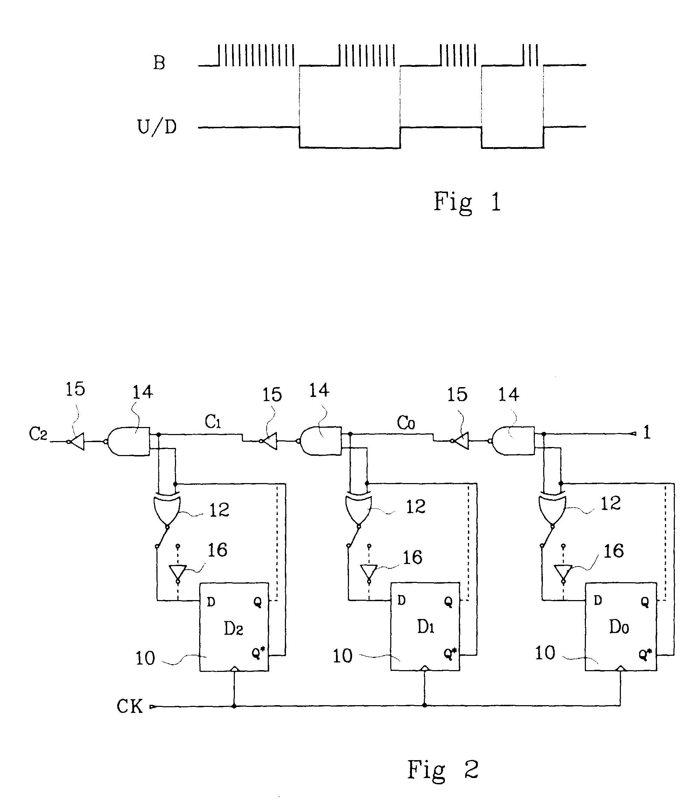

La figure 1 représente quatre trains d'impulsions d'un signal B. Ce signal B est appliqué à l'entrée de comptage d'un compteur/décompteur classique. Un tel compteur/décompteur possède classiquement une entrée U/D permettant de le commuter en mode comptage ou en mode décomptage. La figure 1 représente également l'allure d'un signal U/D permettant, par exemple, de compter les impulsions des trains de rang impair et de décompter les impulsions des trains de rang pair. L'état du signal U/D bascule à chaque fin d'un train d'impulsions. Plus généralement, il pourrait basculer à n'importe quel instant entre deux trains d'impulsions.

Un tel comptage permet, par exemple, de déterminer la différence de largeur de deux impulsions basse fréquence successives en observant et en mettant à zéro le contenu du compteur/décompteur à chaque nombre pair d'impulsions basse fréquence. Pour obtenir le signal B, on combine dans une porte logique un signal d'horloge haute fréquence et les impulsions basse fréquence à mesurer. Bien entendu, il faut que le compteur/décompteur puisse fonctionner à la haute fréquence du signal d'horloge.

L'architecture des compteurs/décompteurs classiques est synchrone. C'est-à-dire que ces compteurs comprennent une pluralité de bascules toutes pilotées par un même signal de comptage. Le fait qu'une bascule change ou non d'état lors d'une impulsion du signal de comptage est déterminé par des circuits logiques périphériques.

Dans un premier type de compteur/décompteur synchrone classique, par exemple celui fabriqué par la Société Texas Instruments sous l'appellation SN74HC191, les circuits logiques périphériques comprennent, pour chaque bascule de rang N, une porte logique à N-1 entrées. En technologie CMOS, la durée de basculement d'une porte est fonction du carré du nombre d'entrées. Le basculement de l'une quelconque de ces portes à multiples entrées détermine le changement d'état de la bascule correspondante. Ainsi, la fréquence maximale de ce type de compteur/décompteur est limitée par le temps de basculement de la porte à plus grand nombre d'entrées (N-1).

La figure 2 représente une autre architecture de compteur/décompteur synchrone. Le compteur/décompteur a été représenté dans une configuration de décomptage.

Un tel compteur/décompteur à N bits est constitué de N cellules identiques disposées en cascade. Chaque cellule comprend une bascule 10 de type D, une porte NON-OU Exclusif 12 à deux entrées, et une porte ET à deux entrées constituée en pratique d'une porte NON ET 14 suivie d'un inverseur 15. La bascule 10 est reliée à une ligne de comptage CK commune à toutes les bascules. La sortie de la porte NON OU Exclusif 12 est reliée à l'entrée de donnée D de la bascule. Les deux entrées de la porte NON OU 12 sont reliées en parallèle sur deux entrées de la porte NON ET 14. La sortie de la porte 14/15 délivre un signal de retenue C (C₀, C₁, C₂...) à l'une des entrées communes des portes 12 et 14 de la cellule de rang supérieur. Pour la cellule de premier rang, cette entrée commune reçoit l'état 1. L'autre entrée commune des portes 12 et 14 est reliée à la sortie inversée Q∗ de la bascule 10.

En mode comptage, comme cela est représenté en pointillés : la sortie de la porte NON OU Exclusif 12 est reliée à l'entrée de donnée D de la bascule par l'intermédiaire d'un inverseur 16 ; la sortie non-inversée Q est reliée à cette autre entrée commune ; et ce sont les sorties Q des bascules qui fournissent l'état du compteur.

Décrire le fonctionnement du circuit de la figure 2 n'est pas utile dans le présent exposé mais on retiendra que dans certains cas, le 1 présent à l'entrée de la première porte 14 doit être propagé vers la dernière porte 14 avant l'arrivée de la prochaine impulsion sur la ligne CK. Ceci se produit, par exemple, en mode décomptage, lorsque l'état du compteur passe de l'état 1000... à l'état 0111... Ainsi, la fréquence de comptage d'un tel compteur est limitée par 2(N-1) temps de basculement de porte pour un compteur de N bits.

En pratique, l'architecture de la figure 2 est plus rapide que l'architecture du compteur SN74HC191 pour un nombre de bits élevé. En technologie CMOS classique, un compteur 10 bits selon cette architecture présente une fréquence limite de l'ordre de 42 MHz.

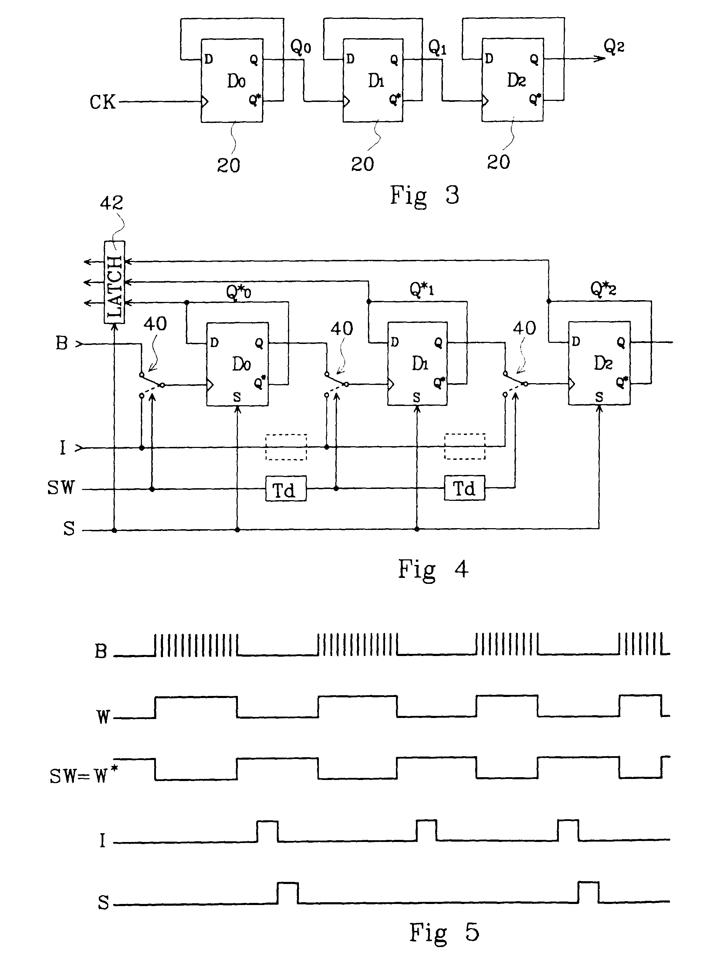

La figure 3 représente une architecture classique de compteur asynchrone. Ce compteur comprend une pluralité de bascules 20 de type D disposées en cascade. L'entrée d'horloge de chaque bascule est reliée à la sortie non inversée Q de la bascule précédente et l'entrée d'horloge de la première bascule reçoit le signal de comptage CK. Chaque bascule est connectée selon une configuration de diviseur par 2, à savoir que la sortie inversée Q* de la bascule est reliée à l'entrée de donnée D de cette même bascule. Avec cette configuration, lorsqu'une bascule reçoit un front actif, généralement montant, sur son entrée d'horloge, elle mémorise l'état de sa sortie inversée Q*, c'est-à-dire que le contenu de la bascule est inversé. Dans un tel compteur dont les bascules sont activées par des fronts montants, si l'on prend comme sortie les sorties non inversées Q, le compteur décompte, et si l'on prend comme sortie les sorties inversées Q*, le compteur compte.

Un compteur asynchrone du type de la figure 3 présente l'avantage que sa fréquence limite est la fréquence limite de la première bascule. En technologie CMOS classique, une bascule de type D présente une fréquence limite de l'ordre de 100 MHz.

Toutefois, un compteur asynchrone ne permet pas, par exemple, de compter jusqu'à une valeur prédéterminée puis de décompter à partir de cette valeur. On ne peut donc utiliser directement un tel compteur pour compter et décompter des trains d'impulsions successifs.

Un compteur asynchrone selon le préambule de la revendication 1 est connu du document US-A-2 823 856.

Un objet de la présente invention est de prévoir une structure de compteur asynchrone permettant de compter et de décompter des trains d'impulsions successifs se suivant à fréquence élevée.

Cet objet est atteint grâce à un compteur asynchrone comprenant une pluralité de bascules connectées en cascade selon des rangs croissants, et des moyens d'inversion de l'état de chacune des bascules et de réinitialisation de toutes les bascules, le compteur comprenant une bascule de verrouillage pour mémoriser l'état de chacune des bascules, le compteur recevant en entrée des trains d'impulsions, les moyens d'inversion agissant après chaque train d'impulsions, avant le train d'impulsions suivant, et les moyens de réinitialisation et la bascule de verrouillage agissant, à partir d'une impulsion d'initialisation, à chaque nombre pair de trains d'impulsions.

Selon un mode de réalisation de la présente invention, les moyens d'inversion comprennent un commutateur reliant chaque entrée d'horloge, soit à la sortie de la bascule de rang précédent pendant la durée d'un train d'impulsions, soit à une ligne fournissant une impulsion de basculement dans chaque intervalle séparant deux trains d'impulsions.

Selon un mode de réalisation de la présente invention, chaque bascule comprend une entrée d'initialisation recevant l'impulsion d'initialisation après chaque nombre pair d'impulsions de basculement.

Selon un mode de réalisation de la présente invention, chaque bascule comprend une sortie inversée reliée à la bascule de verrouillage.

Selon un mode de réalisation de la présente invention, les commutateurs sont commandés par un signal actif pendant les intervalles séparant deux trains d'impulsions, et des moyens de retard décalent ce signal d'un commutateur au commutateur de la bascule de rang suivant.

Selon un mode de réalisation de la présente invention, le nombre de bascules est choisi pour que la valeur binaire maximale du compteur soit supérieure au double de la différence maximale, en valeur absolue, des nombres d'impulsions de deux trains successifs.

Ces objets, caractéristiques et avantages ainsi que d'autres de la présente invention seront exposés en détail dans la description suivante de modes de réalisation particuliers faite en relation avec les dessins joints parmi lesquels :
la figure 1, précédemment décrite, représente des trains d'impulsions que l'on veut successivement compter et décompter ;
la figure 2 représente une structure classique de compteur/décompteur synchrone ;
la figure 3 représente une structure classique de compteur asynchrone ;
la figure 4 représente un mode de réalisation de structure de compteur asynchrone selon l'invention permettant de compter et de décompter des trains d'impulsions successifs ;
la figure 5 représente les allures des signaux exploités par le compteur de la figure 4 ; et
la figure 6 illustre le fonctionnement du compteur de la figure 4 dans deux cas particuliers.

L'invention propose pour compter et décompter des trains d'impulsions successifs, au lieu d'utiliser un compteur/décompteur classique et de commuter son mode entre chaque train d'impulsions, d'utiliser un compteur asynchrone et d'inverser l'état de chacune de ses bascules entre chaque train d'impulsions.

On suppose que le compteur asynchrone peut compter jusqu'à un nombre maximal n, qu'un premier train d'impulsions comprend i impulsions, et qu'un deuxième train d'impulsions comprend j impulsions. Le compteur, préalablement mis à 0, compte de 0 à i lors du premier train d'impulsions. Les états des bascules du compteur sont ensuite inversés, ce qui entraîne que l'on effectue la complémentation à n de la valeur i ; le compteur contient alors la valeur n-i. Lors du deuxième train d'impulsions, le compteur compte de n-i à n-i+j. La différence cherchée est i-j. Or i-j est le complément à n de n-i+j, que l'on obtient en inversant de nouveau les états des bascules.

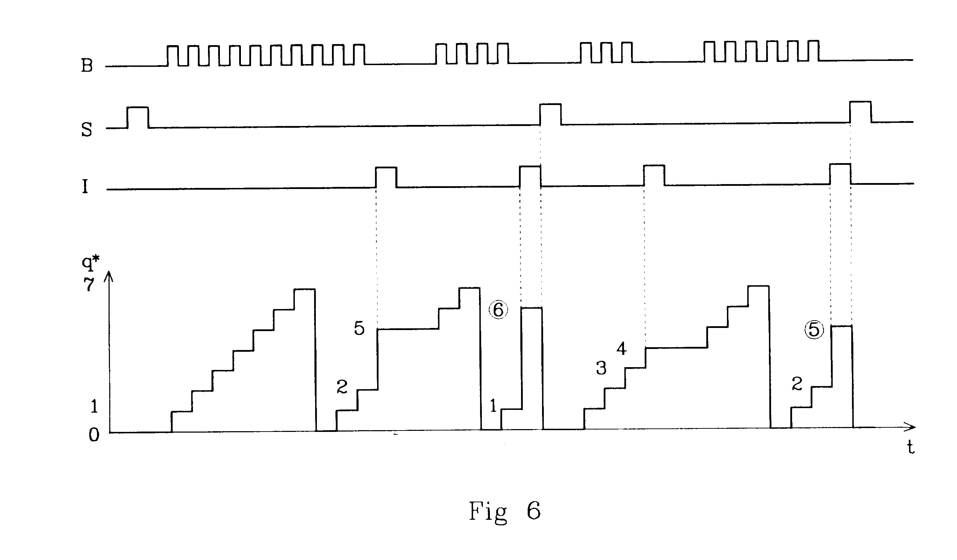

Il importe peu que le compteur déborde, par exemple parce que i est supérieur à n. Le compteur, une fois qu'il a compté jusqu'à n, continue à compter en repartant de 0. Comme on le verra en relation avec la figure 6, la différence i-j est correctement déterminée à condition qu'elle ne soit pas supérieure à n. On choisit donc le nombre de bits du compteur pour que la valeur n soit supérieure à la plus grande valeur possible de la différence i-j.

Le compteur de la figure 4 présente une structure de base similaire à celle du compteur asynchrone de la figure 3. Il comprend une pluralité de bascules de type D (D0, D1, D2,...) disposées en cascade. La sortie inversée Q* de chaque bascule est reliée à l'entrée de donnée D de cette même bascule.

Selon l'invention, l'entrée d'horloge de chaque bascule est, soit reliée à la sortie non-inversée Q de la bascule précédente, soit à une ligne commune I par l'intermédiaire d'un commutateur 40 commandé par une ligne commune SW. Le premier commutateur 40 reçoit des trains d'impulsions B en lieu et place de la sortie Q d'une bascule. Chaque bascule comprend également une entrée d'initialisation S reliée à une ligne commune S. Les sorties prises en compte des bascules sont les sorties inversées Q* qui sont éventuellement reliées à une bascule de verrouillage 42 commandée par le signal S. Les éléments Td sont des circuits de retard dont le rôle sera décrit ultérieurement.

La figure 5 permet d'illustrer le fonctionnement du compteur de la figure 4. On y a représenté quatre trains d'impulsions d'un signal B appliqué à l'entrée du compteur. Dans un circuit permettant d'obtenir les trains d'impulsions B, on dispose généralement aussi d'un signal de fenêtre W qui a permis d'obtenir le signal B en combinant ce signal de fenêtre avec un signal d'horloge haute fréquence à l'aide d'une porte ET, par 1 exemple. Dans ce cas, le signal W est à pendant les trains d'impulsions et à 0 pendant les intervalles entre trains d'impulsions. Le signal SW de commande des commutateurs 40 est par exemple l'inverse logique W* du signal W. En tout cas, le signal SW est tel que les commutateurs 40 relient les bascules D en cascade selon la configuration de la figure 3 au moins pendant les trains d'impulsions, et relient les entrées d'horloge des bascules à la ligne I pendant au moins une partie de l'intervalle entre trains d'impulsions.

Pendant que les entrées d'horloge des bascules sont reliées à la ligne I, on fournit sur cette ligne une impulsion. Alors, comme cela a été décrit en relation avec la figure 3, l'état de chaque bascule est inversé.

En outre, les bascules sont réinitialisées après chaque nombre pair d'impulsions d'inversion I, par exemple comme cela est représenté, après chaque deuxième impulsion I par une impulsion S. On verra en relation avec la figure 6 qu'en agissant ainsi, l'ensemble des sorties Q* des bascules fournit, à chaque deuxième impulsion I, la différence des nombres d'impulsions des deux trains précédents. Les différences successives, le cas échéant, sont mémorisées dans la bascule 42 à chaque impulsion S. Les impulsions S sont en fait des impulsions de mise à 1 pour mettre à 0 les sorties inversées Q*.

L'homme de l'art sait générer les impulsions I et S de diverses façons classiques et simples. Par exemple, les impulsions I peuvent être obtenues en retardant le signal SW deux fois et en combinant à l'aide d'une porte ET le signal une fois retardé avec l'inverse du signal deux fois retardé. Les impulsions S peuvent être obtenues en divisant le signal P par 2 et en combinant dans une porte ET ce signal divisé par 2 avec son inverse retardé.

La figure 6 illustre à l'aide d'exemples numériques le fonctionnement du compteur de la figure 4 dans deux cas de débordement possibles. On a représenté un signal B présentant quatre trains d'impulsions de 10, 4, 3 et 6 impulsions respectivement. Une impulsion S de mise à 1 des sorties Q, et donc de mise à 0 des sorties Q*, est fournie avant le premier train et avant le troisième train. Les impulsions d' inversion I sont fournies après chaque train d'impulsions et, le cas échéant, avant les impulsions S de réinitialisation. On a représenté la valeur décimale, notée q*, définie par l'ensemble des sorties Q* des bascules de la figure 4 dans le cadre d'un compteur à 3 bascules, c'est-à-dire à 3 bits, pouvant compter de la valeur binaire 000 (valeur décimale 0) à la valeur binaire 111 (valeur décimale 7). Avec la notation précédemment utilisée, on a n=7. Puisque la valeur définie par l'ensemble des sorties Q des bascules est le complément à 7 de la valeur q*, on ne décrit ci-après que les évolutions de la valeur q*.

A la première impulsion S, la valeur q* est forcée à 0. A chaque impulsion du premier train de 10 impulsions, la valeur q* est incrémentée. A la huitième impulsion du premier train, le compteur déborde et q* passe à 0. A la fin de ce train, on a q*=2 (010 en binaire). Ensuite survient la première impulsion d'inversion I qui entraîne la complémentation à 7 de la valeur q*. La valeur q* passe à 7-2=5 (101 en binaire).

A chaque impulsion du deuxième train de 4 impulsions, la valeur q* est incrémentée à partir de 5. A la troisième impulsion du deuxième train, le compteur déborde et la valeur q* passe à O. A la fin de ce train, on a q*=1. A la survenue subséquente de la deuxième impulsion I, on a q*=7-1=6. La valeur q*=6 représente bien la différence (10-4) des nombres d'impulsions des premier et deuxième trains. Le fait que le nombre d'impulsions (10) du premier train ait été supérieur à la capacité (7) du compteur n'altère pas le résultat.

Ensuite, survient la deuxième impulsion S de réinitialisation qui force la valeur q* à 0 et, le cas échéant, provoque la mémorisation de la valeur q*=6 obtenue précédemment dans la bascule 42.

Le cycle recommence alors pour les troisième et quatrième trains d'impulsions de respectivement 3 et 6 impulsions. A la fin du troisième train d'impulsions, on a q*=3. La troisième impulsion I survient et q* passe à 7-3=4. Le compteur compte les impulsions du quatrième train depuis la valeur 4 et déborde à la quatrième impulsion. La valeur q* passe à O. A la fin du quatrième train, on a q*=2. Lors de l'impulsion I subséquente, la valeur q* passe à 7-2=5. Cette valeur est égale à la différence cherchée modulo 8 (5 = -3 mod 8). Toutefois, dans cet exemple, il n'est pas possible de distinguer la différence positive 6 de la différence négative -3.

Pour lever cette ambiguïté, l'invention propose d'utiliser un compteur comprenant un bit supplémentaire, c'est-à-dire, dans cet exemple, pouvant compter jusqu'à 15. Alors, le résultat du comptage des premier et deuxième trains d'impulsions est toujours 6. Par contre, le résultat du comptage des troisième et quatrième trains d'impulsions est -3 mod 16 = 13. Si on sait a priori que les différences recherchées ne dépassent pas 7 impulsions, on distinguera une différence positive d'une différence négative par le fait qu'une différence négative correspond à un résultat de comptage compris entre 8 et 15. En binaire, le bit supplémentaire du compteur indiquera par l'état 1 une valeur négative et par l'état 0 une valeur positive. Un circuit logique pourra donc adéquatement traiter les résultats fournis par le compteur. Certains circuits peuvent d'ailleurs directement exploiter ce type de résultat, tels qu'un additionneur classique.

De façon générale, on choisit le nombre de bits du compteur de manière qu'il puisse compter au moins jusqu'au double de la différence maximale, en valeur absolue, des nombres d'impulsions de deux trains successifs.

Dans la précédente description, on n'a pas tenu compte des retards de commutation des bascules. Il serait gênant de commuter un commutateur 40 vers la ligne I alors que l'état Q de la bascule précédente n'a pas eu le temps de changer. Pour éviter cela, on dispose, dans la figure 4, un circuit de retard Td sur la ligne SW entre deux commutateurs 40 successifs. Le retard introduit par un circuit Td est supérieur ou égal au retard de commutation d'une bascule. Dans ce cas, on est sur qu'un commutateur 40 est commuté alors que la bascule précédente a eu le temps de changer d'état. Si les retards introduits par les circuits Td risquent d'être supérieurs à l'intervalle de temps séparant une impulsion d'inversion I de la fin d'un train d'impulsions, on peut également introduire des circuits de retard dans la ligne I entre les commutateurs 40, comme cela est représenté par des rectangles en pointillés.

De nombreuses variantes et modifications de la présente invention apparaîtront à l'homme de l'art, notamment en ce qui concerne la réalisation des commutateurs 40 et la génération des impulsions I et S. On a décrit un exemple où l'on génère une impulsion S à chaque deux impulsions I. On peut envisager de générer une impulsion S à chaque nombre pair quelconque d'impulsions I pour obtenir la somme des différences des nombres impulsions des trains précédents.

## Revendications

1. Compteur asynchrone comprenant une pluralité de bascules (D0-D2) connectées en cascade selon des rangs croissants, et des moyens d'inversion de l'état de chacune des bascules et de réinitialisation de toutes les bascules, caractérisé en ce que le compteur comprend une bascule de verrouillage (42) pour mémoriser l'état de chacune des bascules (D0-D2), en ce que le compteur recevant en entrée des trains d'impulsions (B) et en ce que les moyens (40, SW, I) d'inversion agissent après chaque train d'impulsions, avant le train d'impulsions suivant, et les moyens de réinitialisation (S) et la bascule de verrouillage (42) agissent, à partir d'une impulsion d'initialisation, à chaque nombre pair de trains d'impulsions.

2. Compteur selon la revendication 1, dans lequel les bascules (DO-D2) comprennent une entrée d'horloge et une sortie (Q), caractérisé en ce que les moyens d'inversion comprennent un commutateur (40) reliant chaque entrée d'horloge, soit à la sortie de la bascule de rang précédent pendant la durée d'un train d'impulsions, soit à une ligne (I) fournissant une impulsion de basculement dans chaque intervalle séparant deux trains d'impulsions.

3. Compteur selon la revendication 2, caractérisé en ce que chaque bascule (D0-D2) comprend une entrée d'initialisation (S) recevant l'impulsion d'initialisation (S) après chaque nombre pair d'impulsions de basculement (I).

4. Compteur selon la revendication 3, caractérisé en ce que chaque bascule comprend une sortie inversée (Q*) reliée à la bascule de verrouillage (42).

5. Compteur selon la revendication 2, caractérisé en ce que les commutateurs (40) sont commandés par un signal (SW) qui est actif pendant les intervalles séparant deux trains d'impulsions, et en ce qu'il comprend des moyens de retard (Td) pour retarder ce signal d'un commutateur au commutateur de la bascule de rang suivant.

6. Compteur selon la revendication 1, caractérisé en ce que le nombre de bascules est choisi de manière que la valeur binaire maximale que puisse contenir le compteur soit supérieure au double de la différence maximale, en valeur absolue, des nombres d'impulsions de deux trains successifs.

## Patentansprüche

1. Asynchroner Zähler mit mehreren Kippschaltungen (D0-D2), die in Kaskade nach wachsendem Rang geschaltet sind, und mit Einrichtungen zur Inversion des Zustandes jeder Kippschaltung und zum Rücksetzen aller Kippschaltungen, dadurch gekennzeichnet, dass der Zähler eine Halte-Kippschaltung (42) zum Speichern des Zustandes jeder der Kippschaltungen (D0-D2) aufweist, dass der Zähler am Eingang Impulszüge (B) empfängt, und dass die Einrichtungen (40, SW, I) zur Inversion nach jedem Impulszug vor dem nächstfolgenden Impulszug und die Einrichtungen (S) zum Rücksetzen bei jeder geraden Zahl von Impulszügen tätig werden.

2. Zähler nach Anspruch 1, bei dem die Kippschaltungen (D0-D2) einen Takteingang und einen Ausgang (Q) aufweisen, dadurch gekennzeichnet, dass die Einrichtungen zur Inversion einen Schalter (40) aufweisen, der jeden Takteingang entweder während der Zeitdauer eines Impulszuges mit dem Ausgang der Kippschaltung des vorhergehenden Ranges oder mit einer Leitung (I) verbindet, die einen Schaltimpuls in jedem zwei Impulszüge trennenden Zeitintervall liefert.

3. Zähler nach Anspruch 2, dadurch gekennzeichnet, dass jede Kippschaltung (D0-D2) einen Setzeingang (S) aufweist, der einen Setzimpuls (S) nach jeder geraden Anzahl von Schaltimpulsen (I) empfängt.

4. Zähler nach Anspruch 3, dadurch gekennzeichnet, dass jede Kippschaltung einen invertierenden Ausgang (Q*) aufweist, der mit der Halte-Kippschaltung (42) verbunden ist.

5. Zähler nach Anspruch 2, dadurch gekennzeichnet, dass die Schalter (40) durch ein Signal (SW) gesteuert werden, das während der zwei Impulszüge trennenden Zeitintervalle aktiviert ist, und dass Verzögerungseinrichtungen (Td) vorgesehen sind, um dieses Signal eines Schalters dem Schalter der im Rang folgenden Kippschaltung verzögert zu liefern.

6. Zähler nach Anspruch 1, dadurch gekennzeichnet, dass die Anzahl der Kippschaltungen derart gewählt ist, dass der maximale binäre Wert, den der Zähler enthalten kann, größer ist als der Absolutwert der maximalen Differenz der Anzahl von Impulsen in zwei aufeinander folgenden Impulszügen.

## Claims

1. An asynchronous counter including a plurality of flip-flops (D0-D2) that are connected in cascade according to increasing ranks, and means (40, SW, I) for inverting the state of each flip-flop between two pulse trains, and for resetting all the flip-flops, characterized in that the counter comprises a latch (42) for storing the state of each flip-flop (D0-D2), in that the counter receives pulse trains (B), and in that said inverting means operate after each pulse train, before the following pulse train, and the resetting means (5) and the latch (42) operate, from a set pulse at each even number of pulse trains.

2. The counter of claim 1, wherein said flip-flops (D0-D2) include a clock input and an output (Q), characterized in that the inverting means include a switch (40) connecting each clock input, either to the flip-flop output of the previous rank during the occurrence of a pulse train, or to a line (I) providing a switch pulse during each time interval separating two pulse trains.

3. The counter of claim 2, characterized in that each flip-flop (D0-D2) includes a set input (S) receiving a set pulse (S) after each even number of switch pulse (I).

4. The counter of claim 3, characterized in that each flip-flop includes an inverted output (Q*) connected to the latch (42).

5. The counter of claim 2, characterized in that the switches (40) are controlled by a signal (SW) that is active during the time intervals separating two pulse trains, and including delay means (Td) to delay said signal from a switch to the switch of the flip-flop of next rank.

6. The counter of claim 1, characterized in that the number of flip-flops is selected so that the maximum binary absolute value that can be contained in the counter is higher than twice the maximum difference of the number of pulses of two successive pulse trains.
